# EUROPÄISCHE PATENTSCHRIFT

(11) **EP 0 755 116 B1**
(45) Veröffentlichungstag und Bekanntmachung des Hinweises auf die Patenterteilung: **24.02.1999**
(21) Anmeldenummer: 96111309.9
(22) Anmeldetag: 12.07.1996
(51) Int. Cl.: H03H 11/04

(54) **Schaltungsanordnung zur Glättung einer Spannung**
Circuit for smoothing a voltage
Circuit pour le lissage d'une tension

(30) Priorität: 19.07.1995 DE 19526390
(43) Veröffentlichungstag der Anmeldung: 22.01.1997
(73) Patentinhaber: SIEMENS AKTIENGESELLSCHAFT, 80333 München (DE)
(72) Erfinder: Punzenberger, Manfred, Dipl.-Ing., 4210 Gallneukirchen (DE); Zojer, Bernhard, Dipl.-Ing., 9500 Villach (DE)

(56) Entgegenhaltungen:
- US-A- 5 327 027
- PROCEEDINGS OF THE MIDWEST SYMPOSIUM ON CIRCUITS AND SYSTEMS, CALGARY, AUG. 12 - 15, 1990, Bd. VOL. 1, Nr. CONF. 33, 12.August 1990, JOHNSTONE R H;NOWROUZIAN B; TURNER L E, Seiten 480-483, XP000295157 SUMING ZHENG ET AL: "NOVEL CONTINUOUS-TIME MOSFET-C CIRCUIT STRUCTURES USING COMPONENT SIMULATION"
- ELEKTRONIK, Bd. 33, Nr. 9, Mai 1984, MUNCHEN DE, Seiten 69-72, XP002016768 PAUL SKRITEK: "Steilflankige aktive Filter mit FDNRs"
- U. TIETZE ET AL.: "Halbleiter-Schaltungstechnik" 1990 , SPRIGER-VERLAG , BERLIN, DE XP002016769 * Absatz 14.3; Abbildung 14.16 *

## Beschreibung

Die Erfindung betrifft eine Tiefpaßfilterschaltung zur Glättung einer an zwei Eingangsanschlüssen liegenden Eingangsspannung mit Hilfe eines Tiefpasses und eines gegengekoppelten Verstärkers, wobei der eine Eingang des Verstärkers mit einer Kapazität und der Ausgang des Verstärkers mit einem Ausgangsanschluß verbunden ist.

Eine derartige Schaltungsanordnung zur Glättung einer Eingangsspannung ist beispielsweise aus U. Tietze, Ch. Schenk: Halbleiter-Schaltungstechnik, Springer-Verlag, 7. Auflage, 1988, Seite 400 bekannt. Als Tiefpaß ist dabei ein RC-Glied aus einem Widerstand und einer Kapazität vorgesehen, der ein gegengekoppelter Verstärker als Impedanzwandler nachgeschaltet ist. Der Ausgang des Impedanzwandlers liegt an einer Ausgangsklemme und über einen ohmschen Spannungsteiler am Bezugspotential. Der Spannungsabgriff des Spannungsteilers ist auf den invertierenden Eingang des Operationsverstärkers gekoppelt. Die bekannte Schaltung erlaubt weitgehend belastungsunabhängige Eigenschaften des Tiefpasses und eine freie Wahl der Gleichspannungsverstärkung.

Eine weitere gattungsgemäße Schaltungsanordnung (Kapazitätsmultiplizierer) zur Glättung einer an zwei Eingangsanschlüssen anliegenden Spannung ist aus der US-A-5,327,027 bekannt.

Insbesondere bei einer integrierten Schaltungsanordnung hat die bekannte Glättungsschaltung den Nachteil, daß nur sehr kleine Zeitkonstanten realisierbar sind. Sowohl der Widerstand als auch die Kapazität benötigen auf einem Chip eine große Fläche, wodurch hohe Chipkosten entstehen. Ein externer RC-Tiefpaß benötigt andererseits Elemente mit hoher Spannungsfestigkeit und zusätzlichen Aufwand an Anschlußpins.

Der Erfindung liegt die Aufgabe zugrunde, eine Schaltungsanordnung zur Glättung einer Eingangsspannung anzugeben, die eine Kapazität mit geringer Spannungsfestigkeit benötigt und weitestgehend integrierbar ist.

Erfindungsgemäß wird diese Aufgabe durch eine Tiefpaßfilterschaltung mit den Merkmalen der Patentansprüche 1 und 2 gelöst.

Ausgestaltungen der Erfindung sind in Unteransprüchen gekennzeichnet.

Die Erfindung wird nachfolgend anhand dreier in den Figuren der Zeichnung dargestellter Ausführungsbeispiele näher erläutert. Es zeigen:
- FIG 1: ein erstes Ausführungsbeispiel mit einem Stromspiegel als Wandlerelement,
- FIG 2: ein zweites Ausführungsbeispiel mit einer Transkonduktanz als Wandlerelement und
- FIG 3: ein drittes Ausführungsbeispiel mit einer bezugsspannungsfreien Ausgangsspannung.

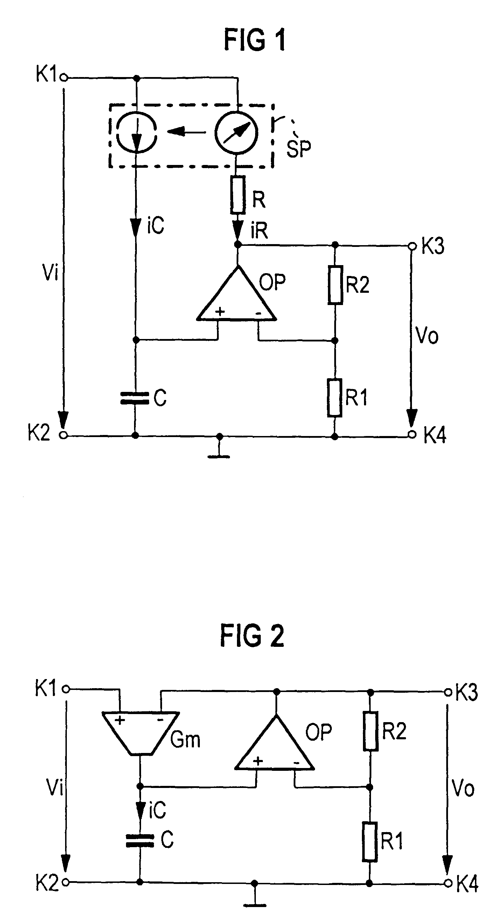

Gemäß FIG 1 liegt an zwei Eingangsklemmen K1 und K2 eine Eingangsspannung Vi. Die Klemme K1 ist mit zwei Anschlüssen eines Stromspiegels SP verbunden, dessen Realisierung dem Fachmann geläufig ist. Stromspiegel sind beispielsweise aus der genannten Veröffentlichung Tietze/Schenk, Seite 62 bekannt. Der Stromspiegel weist zwei Zweige auf. Der eine Zweig ist mit dem nicht invertierenden Eingangsanschluß eines Operationsverstärkers OP und einer Kapazität C verbunden. Der andere Zweig ist über einen Widerstand R mit dem Ausgang des Operationsverstärkers OP verbunden. Der Ausgang des Operationsverstärkers OP ist mit einer Ausgangsklemme K3 und einem ohmschen Spannungsteiler aus den Widerstandselementen R2 und R1 verbunden. Der Spannungsabgriff des ohmschen Spannungsteilers liegt am invertierenden Eingang des Operationsverstärkers. Die zweiten Anschlüsse der Kapazität C und des Widerstands R1 sowie die Klemmen K2 und eine zweite Ausgangsklemme K4 liegen auf Bezugspotential. Zwischen den Klemmen K3 und K4 liegt die geglättete Ausgangsspannung Vo.

Das Prinzip der Schaltung gemäß FIG 1 entspricht dem eines RC-Tiefpasses erster Ordnung. Dabei erzeugt der Widerstand R einen Strom iR, der der Spannungsdifferenz zwischen der Eingangsspannung Vi und der Ausgangsspannung Vo proportional ist. An der Kapazität C wird der Strom iR integriert. Die Kapazität C kann als externes Bauelement realisiert werden, während der Rest der Schaltungsanordnung integrierbar ist. Die Elemente OP sowie R1 und R2 bilden einen internen Spannungsverstärker und Impedanzwandler. Diese mit Hilfe des ohmschen Spannungsteilers gegengekoppelte Verstärkerschaltung hat die Gleichspannungsverstärkung k = 1 + R2/R1 . Da am nicht invertierenden Eingang des Operationsverstärkers OP die Spannung an der Kapazität C abgegriffen wird, ergibt sich somit die Ausgangsspannung Vo der Schaltungsanordnung als die um den Faktor k verstärkte Spannung an der Kapazität C. Anders ausgedrückt ist die am Ausgang wirksame Kapazität um den Faktor k niedriger als die Kapazität C. Der Ladestrom iC für die Kapazität C wird mit Hilfe des durch den Widerstand R fließenden Stroms iR und den Stromspiegel SP erzeugt.

FIG 2 unterscheidet sich von FIG 1 dadurch, daß der Widerstand R und der Stromspiegel durch eine Transkonduktanz Gm ersetzt sind. Dabei ist der nicht invertierende Eingang von Gm mit der Klemme K1 und der invertierende Eingang von Gm mit dem Ausgang des Operationsverstärkers OP verbunden. Der Ausgang der Transkonduktanz ist mit dem nicht invertierenden Eingang von OP einerseits und der Kapazität C andererseits verbunden. Der Aufbau einer Transkonduktanz, insbesondere als aktives Schaltungselement, ist dem Fachmann geläufig und beispielsweise aus der genannten Veröffentlichung Tietze/Schenk bekannt. Die Transkonduktanz erlaubt eine vergleichsweise große Differenzeingangsspannung an ihren Eingängen und eine hohe Flexibilität bezüglich der Zeitkonstanten der Schaltungsanordnung, des statischen Spannungsabfalls und des Einschwingverhaltens der Anordnung.

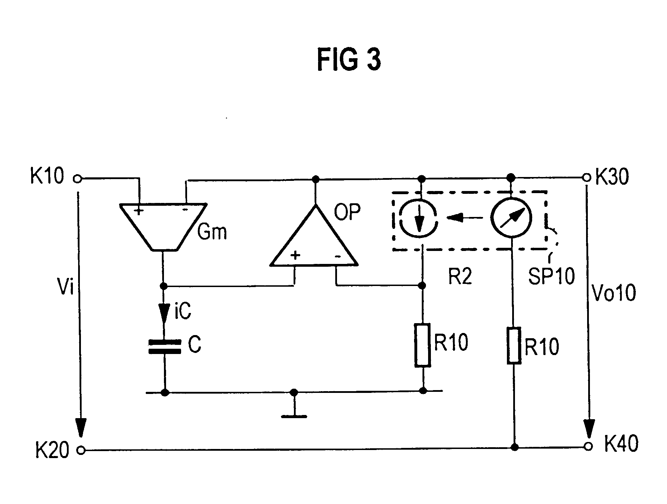

FIG 3 unterscheidet sich von der Schaltung gemäß FIG 2 dadurch, daß nur die Kapazität C und der Widerstand R10 mit Bezugspotential verbunden sind. Der Widerstand R2 gemäß FIG 2 ist durch einen Widerstand R20 und einen Stromspiegel SP10 ersetzt, dessen einer Zweig mit dem invertierenden Eingang des Operationsverstärkers OP verbunden ist und den Widerstand R10 speist und dessen anderer Zweig den Widerstand R20 speist. Der freie Anschluß von R20 und die Klemmen K20 und K40 als Bezugsklemmen der Eingangsspannung Vi10 und der Ausgangsspannung VolO sind miteinander verbunden. R10 und R20 erfüllen auch in dieser Schaltungsvariante die Funktion eines Spannungsteilers. Die Anordnung gemäß FIG 3 ermöglicht es, die Kapazität C an Bezugspotential zu schalten, obwohl die Eingangsspannung und die Ausgangsspannung der Schaltungsanordnung keinen Massebezug aufweisen, d.h. bezugsspannungsfrei sind.

## Patentansprüche

1. Tiefpaßfilterschaltung zur Glättung einer an zwei Eingangsanschlüssen (K1, K2) liegenden Eingangsspannung (Vi) mit Hilfe eines Tiefpasses und eines gegengekoppelten Verstärkers (OP), wobei der eine Eingang des Verstärkers (OP) mit einer Kapazität (C) und der Ausgang des Verstärkers (OP) mit einem Ausgangsanschluß (K3) verbunden ist,
**dadurch gekennzeichnet,**
daß ein Stromspiegel (SP) mit mindestens drei Anschlüssen vorgesehen ist,
- dessen erster Anschluß mit dem ersten Eingangsanschluß (K1) verbunden ist,
- dessen zweiter Anschluß mit dem einen Eingang (+) des Verstärkers (OP) und der Kapazität (C) verbundenen ist und
- dessen dritter Anschluß über einen Widerstand (R) mit dem Ausgang des Verstärkers (OP) verbunden ist.

2. Tiefpaßfilterschaltung zur Glättung einer an zwei Eingangsanschlüssen (K1, K2) liegenden Eingangsspannung (Vi) mit Hilfe eines Tiefpasses und eines gegengekoppelten Verstärkers (OP), wobei der eine Eingang des Verstärkers (OP) mit einer Kapazität (C) und der Ausgang des Verstärkers (OP) mit einem Ausgangsanschluß (K3) verbunden ist,
**dadurch gekennzeichnet,**
daß ein Transkonduktanzverstärker (Gm),
- dessen erster Eingang (+) mit dem ersten Eingangsanschluß (K1, K10) verbunden ist,
- dessen zweiter Eingang (-) mit dem Ausgang des Verstärkers (OP) verbundenen ist und
- dessen Ausgang mit dem einen Eingang (+) des Verstärkers (OP) und der Kapazität (C) verbundenen ist.

3. Tiefpaßfilterschaltung nach einem der Ansprüche 1 oder 2,
**dadurch gekennzeichnet,**
daß der gegengekoppelte Verstärker (OP) einen Spannungsteiler (R1, R2) enthält, der mit dem Ausgang des Verstärkers (OP) und einem Bezugspotential verbunden ist und dessen Spannungsabgriff am invertierenden Eingang (-) des Verstärkers (OP) anliegt.

4. Tiefpaßfilterschaltung nach einem der Ansprüche 1 oder 2,
**dadurch gekennzeichnet,**
daß der Ausgang des Verstärkers (OP) mit einem weiteren Stromspiegel (SP 10) verbunden ist, in dessen einen Zweig ein mit Bezugspotential und dem invertierenden Eingang (-) des Verstärkers (OP) verbundener erster Widerstand (R10) angeordnet ist und in dessen zweiten Zweig ein zweiter Widerstand (R20) angeordnet ist, der an seinem freien Ende mit einem weiteren Potential verbunden ist.

## Claims

1. Low-pass filter circuit for smoothing an input voltage (Vi), which is applied to two input terminals (K1, K2), with the aid of a low-pass filter and a negative feedback amplifier (OP), the first input of the amplifier (OP) being connected to a capacitor (C) and the output of the amplifier (OP) being connected to an output terminal (K3),
characterized
in that a current mirror (SP) having at least three terminals is provided,
- the first terminal of which is connected to the first input terminal (K1),
- the second terminal of which is connected to the first input (+) of the amplifier (OP) and to the capacitor (C), and
- the third terminal of which is connected via a resistor (R) to the output of the amplifier (OP).

2. Low-pass filter circuit for smoothing an input voltage (Vi), which is applied to two input terminals (K1, K2), with the aid of a low-pass filter and a negative feedback amplifier (OP), the first input of the amplifier (OP) being connected to a capacitor (C) and the output of the amplifier (OP) being connected to an output terminal (K3),
characterized
in that a transconductance amplifier (Gm) is provided,
- the first input (+) of which is connected to the first input terminal (K1, K10),
- the second input (-) of which is connected to the output of the amplifier (OP), and
- the output of which is connected to the first input (+) of the amplifier (OP) and to the capacitor (C).

3. Low-pass filter circuit according to either of Claims 1 and 2,
characterized
in that the negative feedback amplifier (OP) contains a voltage divider (R1, R2), which is connected to the output of the amplifier (OP) and to a reference-earth potential and whose voltage tap is connected to the inverting input (-) of the amplifier (OP).

4. Low-pass filter circuit according to either of Claims 1 and 2,
characterized
in that the output of the amplifier (OP) is connected to a further current mirror (SP 10), a first resistor (R10) connected to reference-earth potential and to the inverting input (-) of the amplifier (OP) being arranged in the first path of the said current mirror and a second resistor (R20), which is connected to a further potential at its free end, being arranged in the second path of the said current mirror.

## Revendications

1. Circuit de filtrage passe-bas pour le lissage d'une tension d'entrée (Vi) appliquée à deux bornes (K1, K2) d'entrée, à l'aide d'un filtre passe-bas et d'un amplificateur (OP) à contre-réaction, une entrée de l'amplificateur (OP) étant reliée à un condensateur (C) et la sortie de l'amplificateur (OP) étant reliée à une borne (K3) de sortie,
caractérisé par le fait qu'il est prévu un miroir (SP) de courant ayant au moins trois bornes,
- dont la première borne est reliée à la première borne (K1) d'entrée,
- dont la deuxième borne est reliée à une entrée (+) de l'amplificateur (OP) et au condensateur (C), et
- dont la troisième borne est reliée, par l'intermédiaire d'une résistance (R), à la sortie de l'amplificateur (OP).

2. Circuit de filtrage passe-bas pour le lissage d'une tension d'entrée (Vi) appliquée à deux bornes (K1, K2) d'entrée, à l'aide d'un filtre passe-bas et d'un amplificateur (OP) à contre-réaction, une entrée de l'amplificateur (OP) étant reliée à un condensateur (C) et la sortie de l'amplificateur (OP) étant reliée à une borne (K3) de sortie,
caractérisé par le fait qu'il est prévu un amplificateur à transconductance (Gm)
- dont la première entrée (+) est reliée à la première borne (K1, K10) d'entrée,
- dont la deuxième entrée (-) est reliée à la sortie de l'amplificateur (OP), et
- dont la sortie est reliée à une entrée (+) de l'amplificateur (OP) et au condensateur (C).

3. Circuit de filtrage passe-bas selon l'une des revendications 1 ou 2,
caractérisé par le fait que l'amplificateur (OP) à contre-réaction comporte un diviseur de tension (R1, R2), qui est relié à la sortie de l'amplificateur (OP) et à un potentiel de référence, et dont la prise de tension est établie à l'entrée inverseuse (-) de l'amplificateur (OP).

4. Circuit de filtrage passe-bas selon l'une des revendications 1 ou 2,
caractérisé par le fait que la sortie de l'amplificateur (OP) est reliée à un autre miroir (SP 10) de courant, dans une branche duquel est montée une première résistance (R10), reliée au potentiel de référence et à l'entrée inverseuse (-) de l'amplificateur (OP), et dans la seconde branche duquel est montée une seconde résistance (R20), qui est reliée par son extrémité libre à un autre potentiel.
